# EUROPEAN PATENT SPECIFICATION

(11) **EP 4 181 023 B1**
(45) Date of publication and mention of the grant of the patent: **17.07.2024**
(21) Application number: 20944413.2
(22) Date of filing: 07.07.2020
(51) Int. Cl.: G06N 3/065, G06N 3/044, G06N 3/09, H01L 29/06, G06N 3/063, H01L 29/205, B82Y 10/00, H01Q 9/28

(54) **INFORMATION PROCESSING DEVICE AND INFORMATION PROCESSING METHOD**
INFORMATIONSVERARBEITUNGSVORRICHTUNG UND INFORMATIONSVERARBEITUNGSVERFAHREN
DISPOSITIF ET PROCÉDÉ DE TRAITEMENT D'INFORMATIONS

(43) Date of publication of application: 17.05.2023
(73) Proprietor: FUJITSU LIMITED, Kawasaki-shi, Kanagawa 211-8588 (JP)
(72) Inventor: KAWAGUCHI, Kenichi, Kawasaki-shi, Kanagawa 211-8588 (JP)
(74) Representative: Hoffmann Eitle
(86) International application number: PCT/JP2020/026580
(87) International publication number: WO 2022/009314

(56) References cited:
- EP-A2- 2 821 942
- JP-A- 2018 180 701
- JP-A- H06 243 117
- JP-A- H06 243 117
- ANONYMOUS: "Silicon on Insulator - an overview | ScienceDirect Topics", 1 January 2015 (2015-01-01), XP093050240, Retrieved from the Internet <URL:https://www.sciencedirect.com/topics/materials-science/silicon-on-insulator> [retrieved on 20230529]
- RANJAN AMITESH ET AL: "A Review on Bow-Tie Microstrip Patch Antenna", INTERNATIONAL JOURNAL FOR RESEARCH IN APPLIED SCIENCE AND ENGINEERING TECHNOLOGY, vol. 7, no. 12, 1 December 2019 (2019-12-01), pages 452 - 454, XP093050249, Retrieved from the Internet <URL:https://d1wqtxts1xzle7.cloudfront.net/62355096/74_IJRASET26055452-45420200313-83865-ny6m9v-libre.pdf?1584195490=&response-content-disposition=inline;+filename=A_Review_on_Bow_Tie_Microstrip_Patch_Ant.pdf&Expires=1685429378&Signature=T9~11k5yipfc2mbt0KDrFdJehwldGfBBUPcI2joOBL8epL1G4LVv16GTOPvI~4dSznj> [retrieved on 20230530], DOI: 10.22214/ijraset.2019.12074
- KATUMBA ANDREW ET AL: "Neuromorphic Computing Based on Silicon Photonics and Reservoir Computing", IEEE JOURNAL OF SELECTED TOPICS IN QUANTUM ELECTRONICS, IEEE, USA, vol. 24, no. 6, 1 November 2018 (2018-11-01), pages 1 - 10, XP011681811, ISSN: 1077-260X, [retrieved on 20180425], DOI: 10.1109/JSTQE.2018.2821843
- KATUMBA, ANDREW ET AL.: "Neuromorphic Computing Based on Silicon Photonics and Reservoir Computing", IEEE JOURNAL OF SELECTED TOPICS IN QUANTUM ELECTRONICS, vol. 24, no. 6, November 2018 (2018-11-01), XP011681811, DOI: 10.1109/JSTQE.2018.2821843

## Description

### Technical Field

The embodiments discussed herein relate to an information processing apparatus and an information processing method.

### Background Art

As one of computing systems for artificial intelligence (AI), a reservoir computing system, which is a type of recurrent neural network (RNN), is known (see, for example, PTL1). The reservoir computing system includes a network-type device that is formed of non-linear elements and is called a reservoir.

There is a conventional technique of implementing a reservoir with complementary metal-oxide-semiconductor (CMOS) devices. In addition, there is a proposal of implementing a reservoir using a random network of carbon nanotubes (see, for example, NPTL1).

Further, there is a conventional technique of communicating signals between neurons using radio waves in a neural network (for example, PTL2).

### Citation List

### Patent Literatures

[PTL1] Japanese Laid-open Patent Publication No. 2018-180701
[PTL2] Japanese Laid-open Patent Publication No. H06-243117

### Non-Patent Literature

[NPTL1] Hirofumi Tanaka et al., "A molecular neuromorphic network device consisting of single-walled carbon nanotubes complexed with polyoxometalate", Nature Communications volume 9, Article number: 2693, 2018
EP 2 821 942 A2 (UNIV GENT [BE]; IMEC VZW [BE]), 7 January 2015 (2015-01-07), deals with providing good and efficient reservoir computing based on optical systems by providing an input to an input node as a physical quantity, passively propagating the physical quantity between discrete nodes, obtaining readout signals non-linearly related to the physical quantity in a readout node, and combining the readout signals into an output signal, taking training parameters into account.

### Summary of Invention

### Technical Problem

In a reservoir computing system, when an improvement in the integration density of an apparatus is achieved, it becomes possible to improve the performance of a reservoir, such as simplifying the configuration of a large-scale random network for the reservoir. In the case of implementing the reservoir with CMOS devices, however, it is difficult to improve the integration density due to an increase in the number of components and complexity of wiring. In addition, the conventional technique of implementing a reservoir using carbon nanotubes needs to electrically connect the carbon nanotubes so as to cause the carbon nanotubes to function as conductive wires, which makes it difficult to improve the integration density and thus to configure multiple terminal inputs and a large-scale random network.

According to one aspect, the present disclosure intends to provide an information processing apparatus including a reservoir unit and an information processing method that enable an improvement in the integration density of an apparatus.

### Solution to Problem

The present invention is defined by the independent claims. Preferred embodiments are defined by the dependent claims. Further aspects and examples are provided for facilitating the understanding of the invention.

### Advantageous Effects of Invention

According to one aspect, the present disclosure makes it possible to improve the integration density of an information processing apparatus including a reservoir unit.

The above and other objects, features and advantages of the present invention will become apparent from the following description read in conjunction with the accompanying drawings representing preferred embodiments.

### Brief Description of Drawings

[FIG. 1] FIG. 1 illustrates an example of an information processing apparatus according to a first embodiment.
[FIG. 2] FIG. 2 illustrates an example of an information processing apparatus according to a second embodiment.
[FIG. 3] FIG. 3 illustrates an example of a transmitting antenna unit, reservoir unit, and receiving antenna unit.
[FIG. 4] FIG. 4 illustrates an example in which the reservoir unit has both a dense area of semiconductor elements and a sparse area of semiconductor elements.
[FIG. 5] FIG. 5 illustrates an example of the reservoir unit using nanowire diodes.
[FIG. 6] FIG. 6 illustrates an example of a weighting unit and learning unit.
[FIG. 7] FIG. 7 is a flowchart illustrating an example flow of a computational process of the information processing apparatus according to the second embodiment.
Description of Embodiments. In the present specification, embodiments which are are non consistent with the wording of the independent claims are explicitly referred to as non claimed embodiments.

Hereinafter, embodiments will be described in detail with reference to the accompanying drawings.

### (First Embodiment)

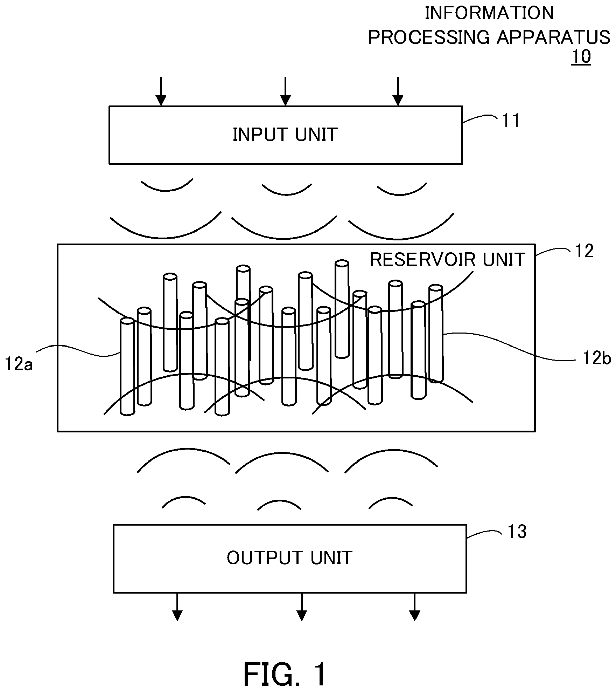

FIG. 1 illustrates an example of an information processing apparatus according to a first embodiment.

The information processing apparatus 10 according to the first embodiment functions as a reservoir computer, and includes an input unit 11, a reservoir unit 12, and an output unit 13.

The input unit 11 converts high-frequency signals into radio waves and emits the radio waves. The high-frequency signals are microwave signals or terahertz-wave signals. The input unit 11 includes one or more antennas according to the number of high-frequency signals to be converted into radio waves, and converts the high-frequency signals into the radio waves with the antennas. In this connection, for example, a high-frequency signal has an amplitude based on the value of an input signal. The input signal is a signal based on a problem to be computed and is, for example, a signal with a value of 1 or 0, a sine wave signal, or another.

The reservoir unit 12 is provided between the input unit 11 and the output unit 13, and outputs radio waves obtained by modulating the radio waves emitted from the input unit 11. The reservoir unit 12 includes a plurality of nanowire diodes that modulate the radio waves emitted from the input unit 11 by exhibiting non-linear response to the radio waves.

In some non-claimed embodiments, the reservoir unit includes a plurality of semiconductor elements, wherein each of the plurality of semiconductor elements that exhibit the non-linear response is a one-dimensional semiconductor or a two-dimensional layered semiconductor.

As the one-dimensional semiconductors, nanowires (for example, indium arsenic (InAs) semiconductor nanowires) may be used. In addition, pn hetero nanowires (also called nanowire diodes), such as p-GaAs (gallium arsenic)/n-InAs, with stronger non-linearity than InAs semiconductor nanowires may be used as the one-dimensional semiconductors. Alternatively, carbon nanotubes may be used as the one-dimensional semiconductors.

As the two-dimensional layered semiconductors, graphene nanoribbons and others are used, for example.

FIG. 1 illustrates an example of using a plurality of one-dimensional semiconductors (one-dimensional semiconductors 12a and 12b and others) as the plurality of semiconductor elements of the reservoir unit 12.

The output unit 13 receives the radio waves (obtained by modulation) output from the reservoir unit 12, and converts the received radio waves into high-frequency signals. For example, the output unit 13 includes one or more antennas according to the number of high-frequency signals to be output, and converts the received radio waves into the high-frequency signals with the antennas. The output unit 13 outputs a computation result based on the amplitudes of the high-frequency signals. For example, the output unit 13 converts the plurality of high-frequency signals obtained by the plurality of antennas into direct current signals, weights each direct current signal by a weight value obtained by training, and outputs a value obtained by adding these as the computation result of the information processing apparatus 10. For example, the computation result is an inference result in the case where the problem to be computed is a problem to infer something, or is a classification result in the case where the problem to be computed is a problem to classify something.

With the information processing apparatus 10 as described above, the signal processing of the reservoir unit 12 that functions as a neural network using fixed values as the weight values (also called coupling coefficients) between neurons is performed using radio waves that propagate in a space. More specifically, high-frequency signals are converted into radio waves by the input unit 11, and the converted radio waves are modulated through non-linear response by the plurality of nanowire diodes of the reservoir unit 12 and are converted back to high-frequency signals by the output unit 13. This information processing apparatus 10 is equivalent to a reservoir computing device having wire connections. However, the information processing apparatus 10 does not need wiring in the reservoir unit 12, which makes it possible to improve the integration density with a simple process. It is thus expected to improve the performance of the reservoir computer, such as simplifying the configuration of a large-scale random network for it.

In addition, in some non-claimed embodiments, the reservoir unit includes a plurality of semiconductor elements, wherein the plurality of semiconductor elements may be configured to have different sizes (for example, one-dimensional semiconductors may have different lengths in the long axis direction) (this may be achieved using manufacturing variance), or the reservoir unit 12 may be provided with an area where semiconductor elements are sparsely arranged and an area where semiconductor elements are densely arranged. This enables an increase in the diversity of the random network, so as to implement the reservoir computer with higher performance.

In addition, in some non-claimed embodiments, in the case of using one-dimensional semiconductors as the semiconductor elements, the antenna effect of the semiconductor elements themselves causes sufficient interaction between the semiconductor elements that are nodes of the random network and propagating radio waves, which enables the reservoir unit 12 to perform signal processing similar to that in the case of using network-type elements.

In this connection, reservoir computing performs training by adjusting weight values for output signals of a reservoir layer. Likewise, the above-described information processing apparatus 10 is able to perform training by adjusting the weight values for the direct current signals obtained by converting the high-frequency signals obtained from the radio waves output from the reservoir unit 12. A configuration example for the training will be described later.

### (Second Embodiment)

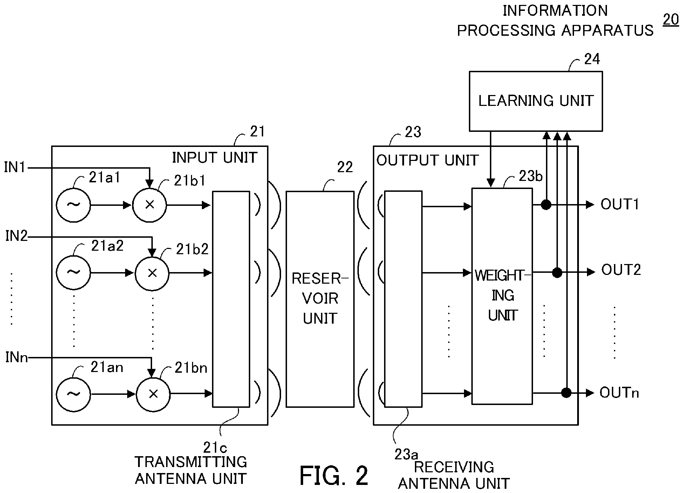

FIG. 2 illustrates an example of an information processing apparatus according to a second embodiment.

The information processing apparatus 20 of the second embodiment includes an input unit 21, a reservoir unit 22, an output unit 23, and a learning unit 24.

The input unit 21 includes high-frequency power sources 21a1, 21a2, ..., 21an, multipliers 21b1, 21b2, ..., 21bn, and a transmitting antenna unit 21c.

The high-frequency power sources 21a1 to 21an output high-frequency signals. The high-frequency signals output from the high-frequency power sources 21a1 to 21an have the same frequency. In this connection, the number of high-frequency power sources 21a1 to 21an may be one, and a high-frequency signal from one high-frequency power source may be supplied in common to the multipliers 21b1 to 21bn.

Each of the multipliers 21b1 to 21bn outputs the product of a received high-frequency signal and a corresponding one of input signals IN1, IN2, ..., INn. Thereby, the strengths (amplitudes) of the n high-frequency signals output from the multipliers 21b1 to 21bn respectively reflect the input signals IN1 to INn.

The transmitting antenna unit 21c includes an antenna that converts the high-frequency signals output from the multipliers 21b1 to 21bn into radio waves and emits the radio waves.

In this connection, a plurality of antennas may be provided, and the number of antennas does not need to match the number of input signals IN1 to INn (the number of multipliers 21b1 to 21bn). For example, a high-frequency signal output from one of the multipliers 21b1 to 21bn may be input to the plurality of antennas, or high-frequency signals output from the plurality of multipliers may be input to one antenna. An example of the antenna will be described later.

The reservoir unit 22 outputs radio waves obtained by modulating the radio waves emitted from the antenna of the input unit 21. The reservoir unit 22 includes a plurality of nanowire diodes that modulate the radio waves emitted from the input unit 21 by exhibiting non-linear response to the radio waves. An example of the reservoir unit 22 will be described later.

The output unit 23 includes a receiving antenna unit 23a and a weighting unit 23b.

The receiving antenna unit 23a receives the radio waves modulated by the reservoir unit 22 and converts the received radio waves into high-frequency signals. For example, the output unit 23 has one or more antennas according to the number of high-frequency signals into which the received radio waves are converted, and converts the received radio waves into high-frequency signals with the antennas.

The weighting unit 23b weights direct current signals obtained by converting the high-frequency signals and outputs the weighted signals or signals by adding the plurality of weighted signals as output signals OUT1, OUT2, ..., OUTn.

In this connection, the number of output signals OUT1 to OUTn does not need to match the number of antennas provided in the receiving antenna unit 23a. In addition, the number of output signals OUT1 to OUTn does not need to match the number of input signals IN1 to INn. For example, the number of output signals OUT1 to OUTn may be one.

The learning unit 24 obtains teacher data and adjusts the magnitude of the weighting performed by the weighting unit 23b on the basis of the teacher data and the output signals OUT1 to OUTn of the output unit 23.

Examples of the weighting unit 23b and learning unit 24 will be described later.

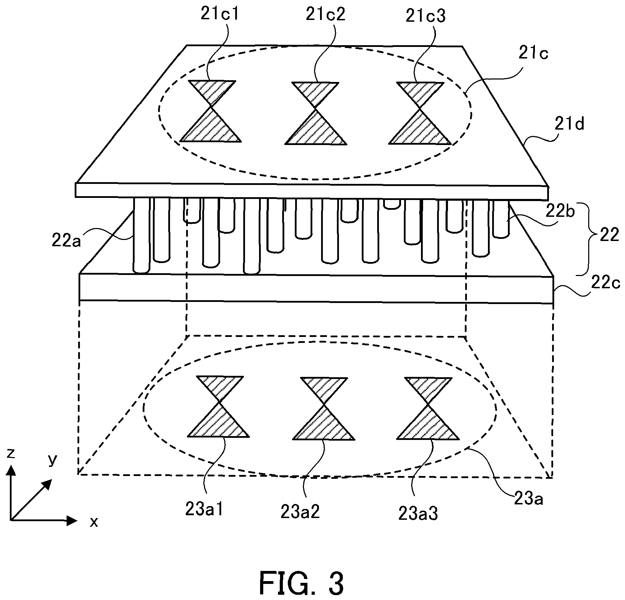

FIG. 3 illustrates an example of the transmitting antenna unit, reservoir unit, and receiving antenna unit.

The transmitting antenna unit 21c includes bowtie antennas 21c1, 21c2, and 21c3. Each bowtie antenna 21c1 to 21c3 is formed by a pair of electrodes whose triangles have apices facing each other. The bowtie antennas 21c1 to 21c3 are formed on a substrate 21d.

The use of the bowtie antennas 21c1 to 21c3 makes it possible to emit radio waves obtained by converting high-frequency signals to the reservoir unit 22 efficiently because of a bowtie antenna effect.

In some non-claimed embodiments, the reservoir unit 22 illustrated in FIG. 3 includes a plurality of InAs semiconductor nanowires (InAs semiconductor nanowires 22a and 22b and others, for example) as the plurality of semiconductor elements that exhibit non-linear response. For example, the plurality of InAs semiconductor nanowires are formed on a substrate 22c such as a silicon (Si) substrate so as to extend in the z direction by crystal growth.

In this connection, the InAs semiconductor nanowires may be arranged regularly on the substrate 22c, but may preferably be arranged randomly in order to increase the diversity of the random network.

Note that, in the semiconductor elements that exhibit non-linear response to high-frequency signals converted into radio waves, their strengths of the interactions with the high-frequency signals depend on their lengths in the long axis direction. As the interactions become stronger, the reservoir unit 22 has higher performance.

Especially, the length of a semiconductor element in the long axis direction is preferably greater than or equal to 1/10 the effective wavelength of a high-frequency signal (the value obtained by dividing the wavelength by the refractive index of the semiconductor element), because such a semiconductor element itself has a remarkable antenna effect and has a stronger interaction with the high-frequency signal.

In general, nanowires such as InAs semiconductor nanowires have a wire length of several µm to 100 µm. Assuming microwave and terahertz-wave high-frequency signals, such high-frequency signals have a wavelength of several hundred µm to several cm. Therefore, in the case of using nanowires, the longer in the long axis direction, the more preferred. Especially, in the case where the wire length in the long axis direction is greater than or equal to 1/10 the effective wavelength of a high-frequency signal, as described above, the nanowires themselves have a remarkable antenna effect. Therefore, for example, in the case where a minimum frequency of 250 GHz (a wavelength of 1200 µm) is set for the frequencies of the high-frequency signals, the wire lengths of the InAs semiconductor nanowires may be set to 1200/(3.5 × 10) = 34 (µm) or more, considering that InAs has a refractive index of 3.5.

In some non-claimed embodiments, with this, the reservoir unit 22 with high performance may be implemented with fewer InAs semiconductor nanowires. For example, in the case of using InAs semiconductor nanowires with a wire length of 3.4 µm, the InAs semiconductor nanowires need to be formed with a density that is 10 times as high as that in the case with a wire length of 34 µm, in order to achieve the same performance.

The reservoir unit 22 is spatially separated from the input unit 21 including the transmitting antenna unit 21c by the substrate 21d, and is also spatially separated from the output unit 23 including the receiving antenna unit 23a by the substrate 22c.

In some non-claimed embodiments,in this connection, in the reservoir unit 22, a plurality of regions where semiconductor elements as described above are formed may be layered in the z direction. For example, a plurality of layers where InAs semiconductor nanowires are formed on the substrate 22c by crystal growth in the z direction may be layered in the z direction. This makes it possible to configure a large-scale random network.

In addition, in some non-claimed embodiments, in the reservoir unit 22, an area where semiconductor elements are sparsely arranged and an area where semiconductor elements are densely arranged may coexist.

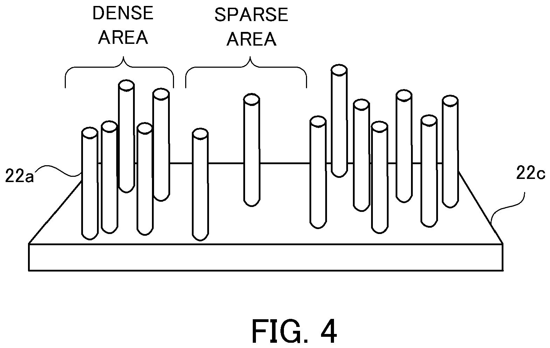

FIG. 4 illustrates an example in which the reservoir unit has both a dense area of semiconductor elements and a sparse area of semiconductor elements.

In the example of FIG. 4, an area where InAs semiconductor nanowires (InAs semiconductor nanowire 22a and others) are densely arranged and an area where InAs semiconductor nanowires are sparsely arranged coexist.

This enables an increase in the diversity of the random network, so as to implement the reservoir computer with higher performance.

Note that, in place of the InAs semiconductor nanowires, nanowire diodes of pn hetero junction type, such as p-GaAs/n-InAs, with stronger non-linearity than the InAs semiconductor nanowires may be used as the nanowires.

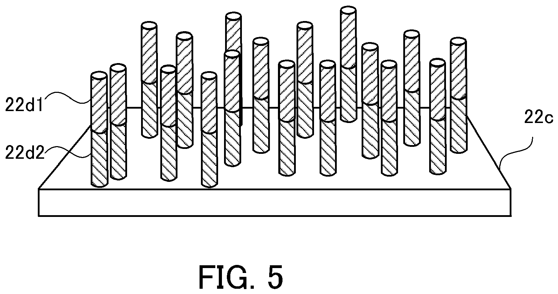

FIG. 5 illustrates an example of a reservoir unit using nanowire diodes.

The nanowire diodes are each formed by joining a p-type semiconductor 22d1 and an n-type semiconductor 22d2. For example, the p-type semiconductor 22d1 is p-type GaAs, whereas the n-type semiconductor 22d2 is n-type InAs.

The nanowire diodes exhibit strong non-linearity and therefore enable the reservoir unit 22 to have higher performance.

In this connection, carbon nanotubes may be used as an example of the one-dimensional semiconductors.

Referring to FIG. 3, the receiving antenna unit 23a includes bowtie antennas 23a1, 23a2, and 23a3. The bowtie antennas 23a1 to 23a3 are formed on the rear surface of the substrate 22c that has nanowire diodes formed on the front surface thereof.

The use of the bowtie antennas 23a1 to 23a3 makes it possible to receive high-frequency signals converted into radio waves from the reservoir unit 22 efficiently because of a bowtie antenna effect.

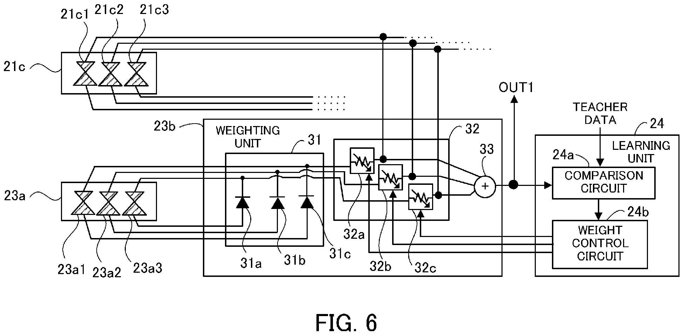

FIG. 6 illustrates an example of the weighting unit and learning unit.

In this connection, FIG. 6 illustrates an example of generating one output signal OUT1 from high-frequency signals obtained through conversion by three bowtie antennas 23a1 to 23a3, for simple description.

The weighting unit 23b includes a direct current (DC) conversion unit 31, weight adjustment unit 32, and an addition unit 33.

The DC conversion unit 31 converts high-frequency signals obtained by converting radio waves with the receiving antenna unit 23a, into direct current signals (direct-current voltage or current amplitude signals).

Referring to the example of FIG. 6, the DC conversion unit 31 includes diodes 31a, 31b, and 31c. The anode of the diode 31a is connected to one of the pair of electrodes of the bowtie antenna 23a3, and the cathode of the diode 31a is connected to the other of the pair of electrodes of the bowtie antenna 23a3. The anode of the diode 31b is connected to one of the pair of electrodes of the bowtie antenna 23a2, and the cathode of the diode 31b is connected to the other of the pair of electrodes of the bowtie antenna 23a2. The anode of the diode 31c is connected to one of the pair of electrodes of the bowtie antenna 23a1, and the cathode of the diode 31c is connected to the other of the pair of electrodes of the bowtie antenna 23a1. Direct current signals respectively output from the cathodes of the diodes 31a, 31b, and 31c are outputs of the DC conversion unit 31.

The weight adjustment unit 32 weights the direct current signals output from the DC conversion unit 31. The magnitude of the weighting is adjusted by the learning unit 24.

In FIG. 6, the weight adjustment unit 32 includes memristors (variable resistance memories) 32a, 32b, and 32c as an example of analog memories holding the magnitude of the weighting. The direct current signals output from the cathodes of the diodes 31a, 31b, and 31c are respectively weighted according to the magnitudes of the resistances of the memristors 32a, 32b, and 32c controlled by the learning unit 24.

The addition unit 33 outputs the result of adding the weighted direct current signals as the output signal OUT1, which is a computation result of the information processing apparatus 20.

In this connection, as illustrated in FIG. 6, for example, the outputs of the weight adjustment unit 32 or signals subjected to attenuation at a fixed rate by resistors, not illustrated, are respectively added to high-frequency signals that propagate through the signal lines connected to the bowtie antennas 21c1 to 21c3 provided at the input stage. With such a feedback loop, an input is made such that a past output is directly associated with the current input. For example, in training with time-series data, it is possible to perform the training so as to highly reflect the temporal correlation. That is, for a problem in which training for the temporal correlation dominates the performance, the use of the feedback loops makes it possible to achieve high speed training. In this connection, it is possible to activate or deactivate the feedback loops individually by using switches or the like, not illustrated.

For example, the weighting unit 23b as described above may be formed on the same plane as where the bowtie antennas 23a1 to 23a3 are formed on the substrate 22c illustrated in FIG. 3.

The learning unit 24 includes a comparison circuit 24a and a weight control circuit 24b. The comparison circuit 24a outputs a comparison result (for example, an error) of comparing received teacher data with the output signal OUT1.

On the basis of the comparison result, the weight control circuit 24b adjusts the magnitude of the weighting (for example, the magnitudes of the resistances of the memristors 32a, 32b, and 32c) in the weighting unit 23b so as to minimize the error.

In this connection, after the training is complete, the learning unit 24 is cut off from the weighting unit 23b by using a switch or the like, not illustrated.

The learning unit 24 may be a computer that is implemented by using a processor or the like that is a hardware component such as a central processing unit (CPU) or a digital signal processor (DSP). In this connection, the learning unit 24 may include an application specific electronic circuit such as an application specific integrated circuit (ASIC) or field programmable gate array (FPGA). The processor executes programs stored in a memory such as a random access memory (RAM) to control the magnitude of weighting on the basis of the comparison result of comparing the teacher data with the output signal OUT1.

The following describes a flow of a computational process of the information processing apparatus 20 according to the second embodiment.

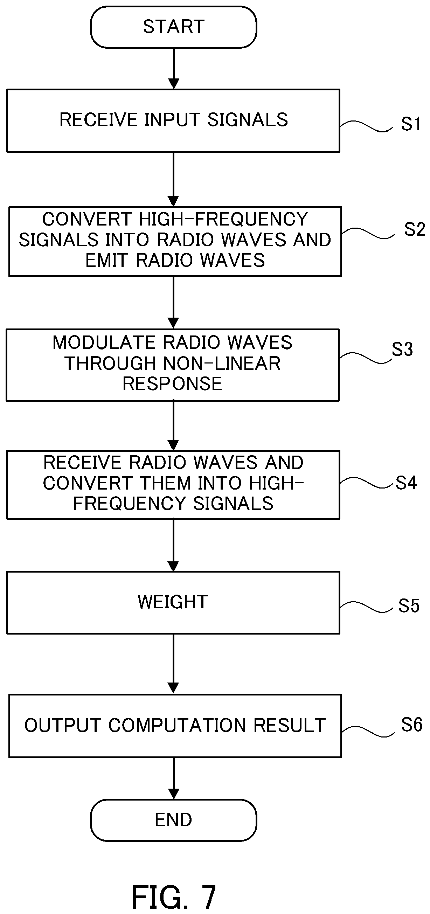

FIG. 7 is a flowchart illustrating an example flow of a computational process of the information processing apparatus according to the second embodiment.

The input unit 21 receives inputs of input signals IN1 to INn (step S1).

Then, in the input unit 21, the transmitting antenna unit 21c converts high-frequency signals reflecting the input signals IN1 to INn into radio waves and emits the radio waves (step S2).

The reservoir unit 22 modulates the radio waves emitted from the input unit 21 by exhibiting non-linear response to the radio waves (step S3).

In the output unit 23, the receiving antenna unit 23a receives the radio waves modulated by the reservoir unit 22 and converts the received radio waves into high-frequency signals (step S4).

In addition, the weighting unit 23b in the output unit 23 weights the direct current signals obtained by converting the high-frequency signals (step S5).

Then, the output unit 23 outputs the weighted signals or signals obtained by adding the plurality of weighted signals as the output signals OUT1 to OUTn that indicate a computation result (step S6). Then, the information processing apparatus 20 completes the computational process.

As with the information processing apparatus 10 of the first embodiment, the above-described information processing apparatus 20 eliminates the need of wiring in the reservoir unit 22, which makes it possible to improve the integration density with a simple process. It is thus expected to improve the performance of a reservoir computer, such as simplifying the configuration of a large-scale random network for it.

The above description is merely indicative of the principles of the present embodiments. A wide variety of modifications and changes may also be made by those skilled in the art. The present embodiments are not limited to the precise configurations and example applications indicated and described above, and all appropriate modifications and equivalents are regarded as falling within the scope of the embodiments as defined by the appended patent claims

### Reference Signs List

- 10: Information processing apparatus
- 11: Input unit
- 12: Reservoir unit
- 12a, 12b: One-dimensional semiconductor
- 13: Output unit

## Claims

1. An information processing apparatus comprising:
an input unit including one or more first antennas configured to convert a first high-frequency signal into a first radio wave and to emit the first radio wave, the first high-frequency signal being microwave signal or terahertz-wave signal;
an output unit including one or more second antennas configured to convert a received second radio wave into a second high-frequency signal, the second high-frequency signal being microwave signal or terahertz-wave signal; and
a reservoir unit, configured to function as a neural network using fixed values as weight values and provided between the input unit and the output unit, including a plurality of nanowire diodes configured to modulate the first radio wave by exhibiting non-linear response to the first radio wave, and to output the second radio wave obtained by modulating the first radio wave.

2. The information processing apparatus according to claim 1, wherein, in the reservoir unit, an area where some of the plurality of nanowire diodes are sparsely arranged and an area where some of the plurality of nanowire diodes are densely arranged coexist.

3. The information processing apparatus according to claim 1 or 2, wherein the one or more first antennas is one or more first bowtie antennas and the one or more second antennas is one or more second bowtie antennas.

4. The information processing apparatus according to any one of claims 1 to 3, wherein the output unit includes a direct current conversion unit and a weight adjustment unit, the direct current conversion unit configured to convert the second high-frequency signal into a direct current signal and the weight adjustment unit configured to weight the direct current signal.

5. The information processing apparatus according to claim 4, further comprising
a learning unit configured to adjust a magnitude of weighting for the direct current signal, based on teacher data, wherein
the input unit is configured to add the weighted direct current signal to the first high-frequency signal.

6. An information processing method comprising:
converting, by an input unit including one or more first antennas, a first high-frequency signal into a first radio wave and emitting the first radio wave, the first high-frequency signal being microwave signal or terahertz-wave signal;
outputting, by a reservoir unit configured to function as a neural network using fixed values as weight values and including a plurality of nanowire diodes configured to modulate the first radio wave by exhibiting non-linear response to the first radio wave, a second radio wave obtained by modulating the first radio wave; and
converting, by an output unit including one or more second antennas, the second radio wave received into a second high-frequency signal, the second high-frequency signal being microwave signal or terahertz-wave signal.

## Patentansprüche

1. Informationsverarbeitungsvorrichtung, umfassend:
eine Eingabeeinheit, die eine oder mehrere erste Antennen einschließt, die konfiguriert sind, um ein erstes Hochfrequenzsignal in eine erste Funkwelle umzuwandeln, und um die erste Funkwelle zu emittieren, wobei das erste Hochfrequenzsignal ein Mikrowellensignal oder ein Terahertzwellensignal ist;
eine Ausgabeeinheit, die eine oder mehrere zweite Antennen einschließt, die konfiguriert sind, um eine empfangene zweite Funkwelle in ein zweites Hochfrequenzsignal umzuwandeln, wobei das zweite Hochfrequenzsignal ein Mikrowellensignal oder ein Terahertzwellensignal ist; und
eine Reservoireinheit, die konfiguriert ist, um als ein neuronales Netzwerk zu funktionieren, das fixierte Werte als Gewichtungswerte verwendet, und die zwischen der Eingabeeinheit und der Ausgabeeinheit bereitgestellt ist, einschließend eine Vielzahl von Nanodrahtdioden, die konfiguriert sind, um die erste Funkwelle zu modulieren, indem sie eine nichtlineare Antwort auf die erste Funkwelle zeigen, und um die zweite Funkwelle auszugeben, die durch Modulieren der ersten Funkwelle erhalten wird.

2. Informationsverarbeitungsvorrichtung nach Anspruch 1, wobei, in der Reservoireinheit, ein Bereich, in dem einige der Vielzahl von Nanodrahtdioden spärlich angeordnet sind, und ein Bereich, in dem einige der Vielzahl von Nanodrahtdioden dicht angeordnet sind, nebeneinander bestehen.

3. Informationsverarbeitungsvorrichtung nach Anspruch 1 oder 2, wobei die eine oder die mehreren ersten Antennen eine oder mehrere erste Bowtie-Antennen sind und die eine oder die mehreren zweiten Antennen eine oder mehrere zweite Bowtie-Antennen sind.

4. Informationsverarbeitungsvorrichtung nach einem der Ansprüche 1 bis 3, wobei die Ausgabeeinheit eine Gleichstrom-Umwandlungseinheit und eine Gewichtungsanpassungseinheit einschließt, wobei die Gleichstrom-Umwandlungseinheit konfiguriert ist, um das zweite Hochfrequenzsignal in ein Gleichstromsignal umzuwandeln, und die Gewichtungsanpassungseinheit konfiguriert ist, um das Gleichstromsignal zu gewichten.

5. Informationsverarbeitungsvorrichtung nach Anspruch 4, weiter umfassend
eine Lerneinheit, die konfiguriert ist, um eine Größe der Gewichtung für das Gleichstromsignal, basierend auf Lehrerdaten, anzupassen, wobei
die Eingabeeinheit konfiguriert ist, um das gewichtete Gleichstromsignal zu dem ersten Hochfrequenzsignal zu addieren.

6. Informationsverarbeitungsverfahren, umfassend:
Umwandeln, durch eine Eingabeeinheit, die eine oder mehrere erste Antennen einschließt, eines ersten Hochfrequenzsignals in eine erste Funkwelle, und Emittieren der ersten Funkwelle, wobei das erste Hochfrequenzsignal ein Mikrowellensignal oder ein Terahertzwellensignal ist;
Ausgeben, durch eine Reservoireinheit, die konfiguriert ist, um als ein neuronales Netzwerk zu funktionieren, das fixierte Werte als Gewichtungswerte verwendet, und einschließend eine Vielzahl von Nanodrahtdioden, die konfiguriert sind, um die erste Funkwelle zu modulieren, indem sie eine nichtlineare Antwort auf die erste Funkwelle zeigen, einer zweiten Funkwelle, die durch Modulieren der ersten Funkwelle erhalten wird; und
Umwandeln, durch eine Ausgabeeinheit, die eine oder mehrere zweite Antennen einschließt, der empfangenen zweiten Funkwelle in ein zweites Hochfrequenzsignal, wobei das zweite Hochfrequenzsignal ein Mikrowellensignal oder ein Terahertzwellensignal ist.

## Revendications

1. Appareil de traitement d'informations comprenant :
une unité d'entrée incluant une ou plusieurs premières antennes configurées pour convertir un premier signal haute fréquence en une première onde radio et pour émettre la première onde radio, le premier signal haute fréquence étant un signal à micro-ondes ou un signal à ondes térahertz ;
une unité de sortie incluant une ou plusieurs deuxièmes antennes configurées pour convertir une deuxième onde radio reçue en un deuxième signal haute fréquence, le deuxième signal haute fréquence étant un signal à micro-ondes ou un signal à ondes térahertz ; et
une unité de réservoir, configurée pour fonctionner en tant que réseau de neurones utilisant des valeurs fixes en tant que valeurs de poids et fournie entre l'unité d'entrée et l'unité de sortie, incluant une pluralité de diodes à nanofil configurées pour moduler la première onde radio en présentant une réponse non linéaire à la première onde radio, et pour délivrer en sortie la deuxième onde radio obtenue en modulant la première onde radio.

2. Appareil de traitement d'informations selon la revendication 1, dans lequel, dans l'unité de réservoir, une zone où certaines de la pluralité de diodes à nanofil sont agencées de façon clairsemée et une zone où certaines de la pluralité de diodes à nanofil sont agencées de façon dense coexistent.

3. Appareil de traitement d'informations selon la revendication 1 ou la revendication 2, dans lequel les une ou plusieurs premières antennes sont une ou plusieurs premières antennes en forme de noeud papillon et les une ou plusieurs deuxièmes antennes sont une ou plusieurs deuxièmes antennes en forme de noeud papillon.

4. Appareil de traitement d'informations selon l'une quelconque des revendications 1 à 3, dans lequel l'unité de sortie inclut une unité de conversion de courant continu et une unité d'ajustement de poids, l'unité de conversion de courant continu configurée pour convertir le deuxième signal haute fréquence en un signal de courant continu et l'unité d'ajustement de poids configurée pour pondérer le signal de courant continu.

5. Appareil de traitement d'informations selon la revendication 4, comprenant en outre
une unité d'apprentissage configurée pour ajuster une grandeur de pondération pour le signal de courant continu, sur la base de données d'enseignant, dans lequel
l'unité d'entrée est configurée pour ajouter le signal de courant continu pondéré au premier signal haute fréquence.

6. Procédé de traitement d'informations comprenant :
la conversion, par une unité d'entrée incluant une ou plusieurs premières antennes, d'un premier signal haute fréquence en une première onde radio et l'émission de la première onde radio, le premier signal haute fréquence étant un signal à micro-ondes ou un signal à ondes térahertz ;
la délivrance en sortie, par une unité de réservoir configurée pour fonctionner en tant que réseau de neurones utilisant des valeurs fixes en tant que valeurs de poids et incluant une pluralité de diodes à nanofil configurées pour moduler la première onde radio en présentant une réponse non linéaire à la première onde radio, d'une deuxième onde radio obtenue en modulant la première onde radio ; et
la conversion, par une unité de sortie incluant une ou plusieurs deuxièmes antennes, de la deuxième onde radio reçue en un deuxième signal haute fréquence, le deuxième signal haute fréquence étant un signal à micro-ondes ou un signal à ondes térahertz.
